Europäisches Patentamt

European Patent Office

Office européen des brevets

(19)

(11) Publication number: **0 106 510 B1**

# EUROPEAN PATENT SPECIFICATION

(12)

(45) Date of publication of patent specification: **13.11.91**

(51) Int. Cl.⁵: **H01J 37/18**, H01J 37/301, H01J 37/317

(21) Application number: **83305269.9**

(22) Date of filing: **08.09.83**

(54) **Envelope apparatus for localized vacuum processing.**

(30) Priority: **19.10.82 US 435179**

(43) Date of publication of application:
**25.04.84 Bulletin 84/17**

(45) Publication of the grant of the patent:
**13.11.91 Bulletin 91/46**

(84) Designated Contracting States:
**CH DE FR GB LI NL**

(56) References cited:
**EP-A- 109 147**      **WO-A-82/02235**
**DE-A- 2 152 100**    **DE-A- 2 207 090**
**US-A- 3 388 235**    **US-A- 3 426 173**

(73) Proprietor: **VARIAN ASSOCIATES, INC.**
**611 Hansen Way**
**Palo Alto, CA 94303(US)**

(72) Inventor: **Lamattina, John R.**
**22 Rosemary Avenue**
**Wakefield, MA(US)**
Inventor: **Petric, Paul Francis**
**12, Dory Way**
**Swampscott, MA(US)**

(74) Representative: **Cline, Roger Ledlie et al**
**EDWARD EVANS & CO. Chancery House**
**53-64 Chancery Lane**
**London WC2A 1SD(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to an output device for use with a vacuum processing apparatus and to such an apparatus for carrying out a process in a vacuum at a localized region on the surface of an article. The invention relates also to to a method of treating the surface of a thin, flexible workpiece with a charged particle beam by means of such an apparatus.

The processing of articles in a vacuum has generally occurred within a sealed chamber, given that processing in the evacuated region outside the earth's atmosphere is not feasible except for specialized space experiments. For vacuum processing on terra firma, articles are loaded into a chamber, and the chamber is then sealed and evacuated. The process of choice is then carried out within the chamber; such processes would include sputtering, vacuum deposition, welding or treatment by a charged particle beam. For example, see H. Kita, et al., "Method of Treating a Workpiece with Electron Beams and Apparatus Therefor," US-A-4,327,273; A. I. Plyshevsky, et al., "Apparatus for Vacuum Coating of a Substrate," US-A-3,990,390.

In the semiconductor processing industry the batch approach has been widely employed. The batch approach requires that the chamber be opened to the external environment when the wafers comprising the batch are loaded and when they are unloaded. This requires a complete pumpdown of the chamber for each successive batch. The breaking of the vacuum of the chamber allows potential contaminants into the system and permits all exposed surfaces within the chamber to adsorb gases. During the ensuing pumpdown these adsorbed gases must be removed in addition to removing the gas filling the volume of the chamber. In addition, such equipment must possess a high level of complexity particularly if automatic loading and transport are features of the equipment. As examples of conventional batch processing by vacuum, see E.H. Voight, et al., "Apparatus for Processing Semiconductor Devices", US-A-3,749,838; C. D. Dobson, "Enclosures for Vacuum Coating," US-A-3,892,198; and D. Maydon, "High Capacity Etching Apparatus," US-A-4,298,443.

In the evolution of vacuum processing techniques, particularly as practiced in the semiconductor processing industry, the tendency has been to more efficiently utilize vacuum. To accomplish efficient vacuum utilization, processing equipment has been developed which minimizes the time required for loading and unloading, which utilizes loadlock chambers to prevent the main processing chamber from returning to ambient each time an article is unloaded from or loaded into the chamber and which reduces the size of the main chamber to minimize the surface area which will adsorb gases and to reduce pumping requirements. Also, the main chamber and processing equipment within the chamber have been fabricated from non-volatile materials so as to reduce outgassing into the chamber.

Serial processing of individual semiconductor wafers has been carried out for many reasons including reducing the size and most often the complexity of the vacuum chamber. In theory, the chamber may be reduced in size to nearly the size of the wafer, as exemplified in the situation where the processing station may form one wall of the chamber. Serial processing is exemplified by the apparatus of J. D. Helms, "Low Volume Deposition Reactor", US-A-3,721,210. In Helms '210 a semiconductor wafer is loaded on a support disk and moved successively to low volume reaction chambers. As disclosed in F.T. Turner, et. al., "Individual Wafer Metalizing System - A Case History," Industrial Research & Development, March, 1982, p. 150, April, 1982, p. 148, individual wafers are introduced from a cassette through a loadlock onto a transfer plate. The wafers are held in place by clips on the transfer plate. The transfer plate is rotated so as to present the wafer for treatment at successive processing stations. The volume of the chamber at each successive station is exceptionally small since the wafer is presented in close coupled opposition to each processing apparatus. Also, each chamber is not opened up to ambient, but is only exposed briefly to the adjacent chamber as the wafer is transferred. Thus, the inefficient use of vacuum associated with batch processing of wafers is thereby eliminated. However, throughput is still affected by the need to load the wafer into a loadlock or into the chamber with the associated requirement of pumping out the volume before commencing processing. And since the semiconductor wafer is loaded into a volume in which a high quality vacuum is ultimately generated, an enclosure at least as large as the wafer is required. Also, the mechanical complexity of the system for wafer transport is still high due to the need for vacuum air interfaces. Since the whole wafer is maintained within the vacuum only radiative thermal transfer is readily available to heat or cool the wafer. Excessive temperature levels may therefore result during such processes as ion implantation or sputter etching. Or, the wafer may not be satisfactorily heated within a vacuum chamber when the process requires heating the wafer.

For focused charged particle beam processing the vacuum region in prior art equipment is usually significantly greater than the localized region at which processing occurs. This localised region may be a spot-sized region or a well-defined scanned field much smaller than the total surface area of the wafer. Typically, the semiconductor wafer is moved relative to the beam while the beam is making small movements in order to obtain full processing of the surface of the wafers. The wafer translation apparatus is also typically included within the vacuum volume thereby increasing the required size and complexity of the vacuum chamber and associated mechanical systems.

US-A-3426173 discloses an electron beam welding system for a workpiece in the form of flat steel stock which is to be welded into a pipe. Handling conditions are vastly different from those required for a thin flexible workpiece, such as a semiconductor wafer. The electron welding beam requires a vacuum system and the main vacuum chamber opening onto the welding site on the workpiece is flanked by subsidiary vacuum chambers of successively higher pressures. The vacuum chambers are each of constant cross section for a considerable distance from the workpiece.

Similar main and subsidiary vacuum chambers of constant cross sections are disclosed in DE-A-2152100 where the workpiece is a cylinder or belt running over a cylinder, and WO-A-8202235 where although the workpiece is a semiconductor wafer, it is located entirely within the main vacuum chamber and is remote from the subsidiary vacuum chambers and from a plane containing the vacuum apertures, and so the same considerations do not apply.

The present invention provides an output device as set out in Claim 1, a vacuum processing apparatus as set out in dependent claim 15 and a method of treating the surface of a thin, flexible workpiece with a charged particle beam as set out in independant claim 16. The output device is for treating the surface of a thin flexible workpiece and at least one of the passages defined by said first and second envelopes is of a truncated conical form extending from the aperture of the respective vacuum envelope. In such an envelope, the increasing cross sectional area provides increasing vacuum conductance between tip and vacuum pump, thereby permitting the localised vacuum area to be pumped to a low pressure. The apertures have sufficiently small areas relative to the given workpiece area to permit treatment of the workpiece surface close to its edge without breaking vacuum in the apertures, which is important in order to avoid waste of valuable surface area and to permit maximum chip density on the wafer, and to minimize bowing of the thin flexible workpiece caused by differential pressure thereacross. A tip area comparable with that of the workpiece would cause bowing and possible breakage of a thin flexible workpiece by vacuum suction.

Examples of the invention will now be described with reference to the accompanying drawings, in which:-

FIG. 1 is a side schematic view of a batch type vacuum processing system;

FIG. 2 is a pictorial side view of localized vacuum processing equipment which incorporates the envelope apparatus of the present invention;

FIG. 3 is a side cross sectional view of an electron beam lithography system which incorporates the envelope apparatus of the present invention;

FIG. 4 is a detailed cross sectional side view of the envelope apparatus for vacuum processing of the present invention;

FIG. 5 is a bottom view of the tip of the vacuum envelope of the present invention;

FIG. 6 is a bottom view of an alternate embodiment of the tip of the vacuum envelope of the present invention;

FIG. 7 is a cross sectional view of the vacuum envelope apparatus of FIG. 6 taken through line 7-7 of FIG. 6;

FIG. 8 is a plan view of a conveyor mechanism holding semiconductor wafers which are to be processed by equipment incorporating the envelope apparatus of the present invention;

FIG. 9 is an expanded cross sectional view of the conveyor mechanism of FIG. 8; and

FIG. 10 is a detailed side view of the apparatus of FIGS. 6 and 7.

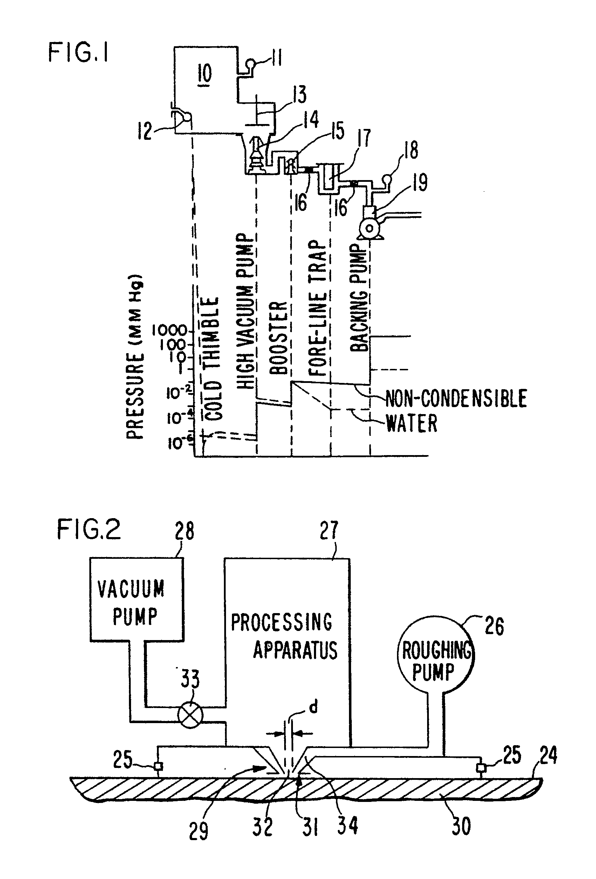

State of the art vacuum processing is accomplished in sealed vacuum chambers. As shown in FIG. 1 a vacuum chamber 10 is evacuated and maintained at high vacuum by high vacuum pump 14 such as a diffusion, ion or cryogenic pump. The high vacuum pump 14 is backed up by roughing pump 19 via cold trap 17 and valves 16. A booster pump 15 or other auxilliary pump, e.g., a Roots blower pump, may be employed for a further intermediate pumping stage. High vacuum valve 13 seals the vacuum pumps from chamber 10 during loading and unloading of the chamber. High vacuum manometer 11 monitors the vacuum in chamber 10 while manometer 18 indicates the roughing vacuum in the foreline. In operation, the article being processed in a vacuum is placed in its entirety into chamber 10. For each batch of articles the system must be fully pumped down to a sufficiently high vacuum level to support the process and the vacuum must be maintained while the process is underway even if outgassing of the chamber walls occurs due to the elevated temperature experienced during the processing. In addition, objects larger than the size of available vacuum chambers may not be subjected to batch vacuum processing.

Localized vacuum processing produces efficient utilization of vacuum and reduces the size and complexity of vacuum processing apparatus. For certain applications it may be permissible to contact the article being processed in order to form the seal. For example, in S. Susei, et al., "Vacuum Shield Device of an Electron Beam Welding Apparatus," US-A-4,342,900, a shield member fabricated from heat-resistant, flexible material is pressed against the article. The open interior of the shield member forms a processing zone where vacuum is maintained to support an electron beam welding process. For certain other applications the processing apparatus may not be allowed to make contact with the wafer. For example, in the processing of semiconductor wafers the upper surface of the wafer must not be contacted so as to avoid damage to regions already processed, to avoid breaking the wafer and to prevent the generation of microparticulates which could interfere with subsequent processing or contaminate the wafer. Thus, when processing semiconductor wafers it is desirable to accomplish localized vacuum processing without physically contacting the wafer.

The vacuum processing system illustrated in Figure 2 includes envelope apparatus 29 which acts as an output device for vacuum processing apparatus 27. Envelope apparatus 29 is attached to the bottom of the processing apparatus 27 and does not make physical contact with the wafer. Envelope apparatus 29 is shown to be conically shaped with truncated end 31 being positioned in opposition to surface 24 of article 30 which is to undergo processing by apparatus 27. For processing flexible articles the envelope apparatus will necessarily be small so as to not produce bowing of the article due to the differential pressure between ambient and the various vacuum regions described below. The high vacuum to support the process is generated by high vacuum pump 28 and is communicated through high vacuum valve 33 to the chamber of processing apparatus 27. The working process is applied to surface 24 through the opening of width d. A graded vacuum seal is formed between truncated end 31 and the surface 24 of the article being processed with high vacuum being present at opening 32 and ambient outside apparatus 29. In between, an intermediate vacuum is present as communicated from roughing pump 26 through annular conical sleeve 34. Additional intermediate vacuum stages may be utilized depending upon the vacuum requirements of the process. A gap is continuously maintained between the end 31 of the envelope apparatus 29 and the surface 24 of the article 30. This gap is either fixed or is dynamically maintained by means 25 within an acceptable range, e.g., 20μm (micrometers) to 40μm (micrometers). The upper end of the range is limited by the gas inflow that can be tolerated while yet maintaining an acceptable vacuum in the internal processing zone. The lower end of the range is determined by the margin required to ensure that no contact is made with the wafer; for the reasons given above contact with the wafer must be avoided at all times.

Gap maintenance techniques include the use of a planar air bearing, the establishment of fixed positions for the article and the envelope apparatus, and the use of air micrometers of the type set out in M. Knobel, "Work Dimension and Position Detecting, Indicating and Controlling Method and Apparatus," US-A-3,194,055. Other gap maintenance systems for use with an envelope apparatus of the type of the present invention are described in EP-A-0106511.

Briefly, such a gap maintenance system comprises sensing means operative to provide a gap sense signal corresponding to the gap measured between the tip of the vacuum envelope and the article being processed. A control means is operative in response to changes in the gap to provide a control signal corresponding to the difference between the measured gap and a desired gap dimension or range of allowed dimensions. An actuating means is operative to vary the gap between the vacuum envelope and the article in response to the control signal. In a preferred embodiment, the actuating means includes three spaced apart, independently controlled actuators coupled through a workpiece holder to the workpiece, and the control means provides independent actuator signals to each of the actuators. The actuating means is thereby operative to vary the angle between the surface of the article being treated and the vacuum envelope when the independent actuators are actuated by unequal amounts.

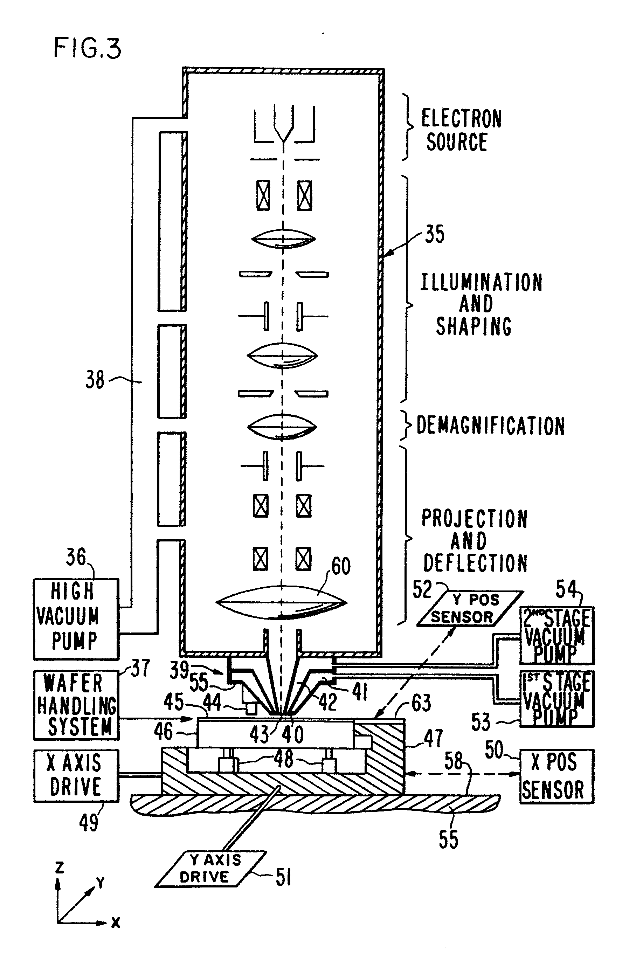

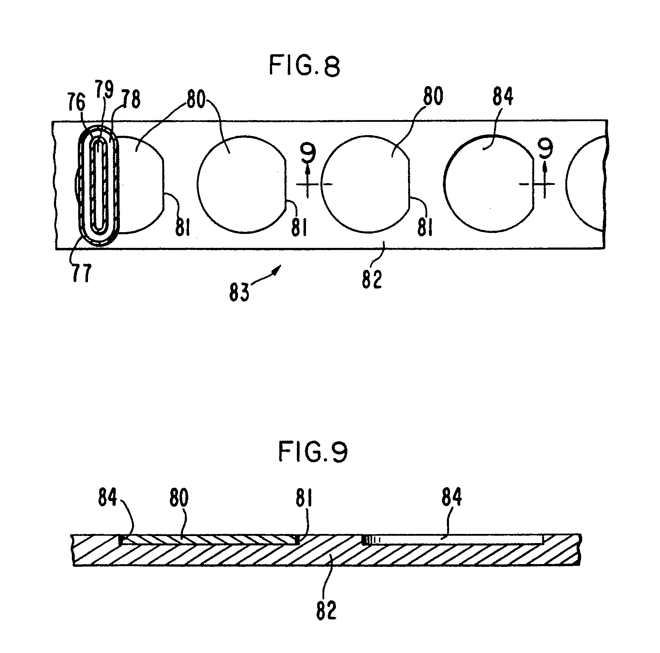

When vacuum is lost or appreciably reduced, the vacuum envelope may have to lock-in to the newly-supplied substrate. Lock-in of the vacuum envelope may occur in several ways. In one embodiment a two-step vacuum lock-in process is employed. Here, before the high quality vacuum of the internal processing zone is established a sensor such as a capacitive sensor is employed to detect the relative proximity of the vacuum envelope to the surface of the article. The vacuum envelope is moved towards the article from above and/or from a laterally displaced position. The capacitive sensor provides information to the positioning means so that the vacuum envelope and the article come together close enough to establish the low level threshold vacuum. Once the low level threshold vacuum level is exceeded the high vacuum source for the internal processing zone is turned on. Then, the gap maintenance system described above is activated and equilibrium vacuum levels for the graded vacuum seal are quickly achieved. For semiconductor wafers of known and uniform thickness, as shown in FIG. 3, the wafers may be placed on a vacuum chuck 46 adjacent an alignment pad 63. The chuck lies below the pad a distance equal to the thickness of the wafer. Thus the stage 47 may be moved laterally with respect to vacuum envelope 39 and vacuum may be retained either over the pad 63 or over the wafer 45. Or, for ion implantation or metallization a link conveyor 83 having wells 84 as shown in FIGS. 8 and 9 may be used.

Within the zone of the envelope apparatus 29 in which vacuum is generated, corresponding to the regional area on the surface of the article being the particular vacuum process, e.g., electron beam welding, ion beam miling, a lithographic process, etc., is carried out. Typically, the vacuum envelope and the substrate are moved relative to each other so that the zone rests above different local regions at different times. The relative movement follows a pattern such that all relevant areas of the article are treated by the vacuum process before the article is removed and a new article is inserted for processing.

Relative movement without contact is readily achieved when articles which have generally planar surfaces which have smoothly varying contours are treated. As a result of the smoothly varying contours few sudden Z-axis movements which might bring the tip of the envelope close to the wafer will be required. The acceptable values for the range of the gap between the tip of the vacuum apparatus and the article also depends upon the quality of the vacuum which is required for processing. If a low quality vacuum can be tolerated, e.g., greater than about $133,3 \times 10^{-4}$ Pa ($10^{-4}$ Torr) as in a welding system, then a larger gap or a workpiece with an irregular surface may be tolerated. If a high quality vacuum is required, e.g., lower than about $133,3 \times 10^{-4}$ Pa (10-4 Torr) as in semiconductor processing, then it is necessary that the gap be closely maintained and that the wafer be flat to within close tolerances. In the semiconductor industry wafers are routinely supplied by vendors with such a high degree of surface flatness. SEMI Standard M1.1 for Polished Monocrystalline Slices dated January 1981 specifies maximum allowable variations in wafer thickness and indicates that future revisions will specify flatness quality as well. In processing in the semiconductor industry, great care is taken to prevent warping of the wafers during processing so that the wafers are amenable to being handled in automated wafer handling equipment. See D. C. Guidici, "Wafer Flatness: An Overview of Measurement Considerations and Equipment Correlation", SPIE, v. 174, Developments in Semiconductor Microlithography IV, p. 132 (1979). High temperature processing, one of the primary sources of warpage, is almost eliminated by employing the apparatus of the present invention. Such warping is one of the most serious problems with semiconductor device processing. See D. Thebault, et al., "Review of Factors Affecting Warpage of Silicon wafers", RCA Review, v. 41, p. 592, December 1980. The elimination of this warpage with the envelope apparatus of the present invention results from exposure of most of the wafer at any point in time to the ambient environment, thereby producing high overall heat transfer between the ambient and the wafer. Heat losses are especially great over that portion of the wafer in the vicinity of the localized region being treated since here the temperature differentials and thus the heat transfer rate is highest. Thus, any wafer warpage is made much less likely so that the gap is more readily maintained within the acceptable range.

As seen in the pictorial representation of FIG. 2, processing apparatus 27 employs the vacuum envelope apparatus 29. The article 30 which is undergoing processing of its surface 24 is presented in spaced apart, close coupled opposition to the tip 31 of envelope apparatus 29. Vacuum sufficient to support the process is supplied by vacuum pump 28 through valve 33 to apparatus 27 and thus to the interior processing zone of envelope apparatus 27. When envelope apparatus 29 is moved with respect to article 30, typically by movement of article 30 but in some cases by movement of processing apparatus 27, portions of the surface area to be treated are successively exposed to the internal processing zone having an orifice 32 of dimension "d" within vacuum envelope apparatus 29. It is evident that the whole surface 24 of article 30 is never subjected in its entirety ot the vacuum and that only a small localized region is subjected to vacuum and the associated processing at any one time. An intermediate vacuum level is produced by roughing pump 26 and communicated to tip 31 through channel 34 which surrounds the internal processing zone. A graded vacuum seal is thus produced between the tip 31 of envelope apparatus 29 and the surface 24 of article 30. The graded vacuum seal extends from internal processing zone, under the opening of channel 34 and out to ambient. The gap between tip 31 and the surface 24 of article 30 may be fixed, if processing vacuum requirements are not severe, or may be dynamically controlled by means 25 as described in detail in EP-A-0106511. The location of the region undergoing processing will change as vacuum envelope apparatus 29 is moved with respect to article 30 by mechanical means (not shown). For beam applications the beam may be steered or scanned to fully or selectively cover that portion of the surface 24 of article 30 which is instantaneously exposed underneath the aperture of vacuum envelope apparatus 29. This combined movement may be of the type disclosed in R. J. Collier, "Electron Beam Exposure System," U.S. Patent No. 3,900,737.

Figure 3 shows in detail envelope apparatus in the context of an electron beam lithography machine, the envelope apparatus having its vacuum envelope 39 attached to the bottom of electron beam column 35. The tip 40 of envelope 39 rests slightly above the surface of semiconductor wafer 45 mounted on vacuum chuck 46. A gap is maintained between the tip 40 of apparatus 39 and the surface of wafer 45. Within this gap a graded radial seal is formed when the machine is in operation. Since vacuum envelope 39 has a truncated conical shape, a radial seal is formed. Since the vacuum envelope 39 has interiorly positioned, spaced apart conical members, a series of discrete zones 43, 42 and 41, each zone being in communication with a vacuum source in the form of a pump. Intermediate zones 41 and 42 are in communication, respectively, with first stage pump 53 and with second stage pump 54. Zone 43 is in communication with high vacuum pump 36 which produces a vacuum sufficient to support the lithographic process. The quality of the vacuum at the tip necessarily reflects the low conductance between pump 36 and tip 40. The vacuum is graded from the level of the ambient environment to a low vacuum level produced by the first stage vacuum pump 53, to a higher vacuum level formed by second stage vacuum pump 54, to the high vacuum level formed by high vacuum pump 36 as communicated to tip 40. Due to low conductance produced by the filling of column 35 with electron optical elements such as lens 60 only a portion of the high vacuum is communicated to tip 40 of vacuum envelope 39. Sufficient high vacuum is, however, delivered through internal zone 43, and sufficient intermediate vacuum is delivered through zones 41 and 42 so that a graded vacuum seal is maintained as relative movement of stage assembly 47 is accomplished with respect to column 35. As a consequence, the point of processing of the working beam on the semiconductor wafer is always maintained under high vacuum even though that point moves over the surface of the semiconductor wafer.

Movement of the stage may be accomplished by any means which is capable of providing prompt, accurate movement in response to control signals such as feedback from an x-y laser interferometer. Short settling time is also a requirement. For example, orthogonal cylindrical air bearings may be employed. See D. R. Herriott, et al., "EBES: A Practical Electron Lithography System," IEEE Transactions on Electron Devices, ED-22, p. 385 (1975). Planar air bearings have also been proposed. See, W. L. Fox, "Vacuum-Sealed Gas-Bearing Assembly", U.S. Patent No. 4,191,385; or a double sided planar air bearing may be utilized. B. G. Lewis, et al., "A Laser Interferometer Controlled X, Y Air Bearing for Direct Wafer Exposure Electron Beam Lithography," Proceedings, 10th International Conference on Electron and Ion Beam Science and Technology, p. 477 (1982). Such air bearing translation means have, however, been bulky, costly and often difficult to maintain in good running order. Preferably, linear motors may be used in a closed loop system as disclosed in EP-A-0109147.

Briefly, linear and smooth operating characteristics for the stage as well as simplicity of design are achieved by using linear motors, for example, linear motors of the Sawyer-principle type. With Sawyer-principle type motors, a moveable stage possesses a network of magnet poles which are wire-wound and function as electromagnets. A baseplate has a matching or complementary network of poles. By appropriate switching of the polarity of the magnets on the moving stage, the poles are intermittently and selectively attracted by counterpart poles on the baseplate. The timing of the switching determines the speed of the motor. Extremely smooth movement is experienced. See, e.g., B.A. Sawyer, "Magnetic Positioning Device", Re 27, 289; J. Dunfield, et.al., "Sawyer-Principle Linear Motor Positions Without Feedback", Power Transmission Design, p. 72, June 1974.

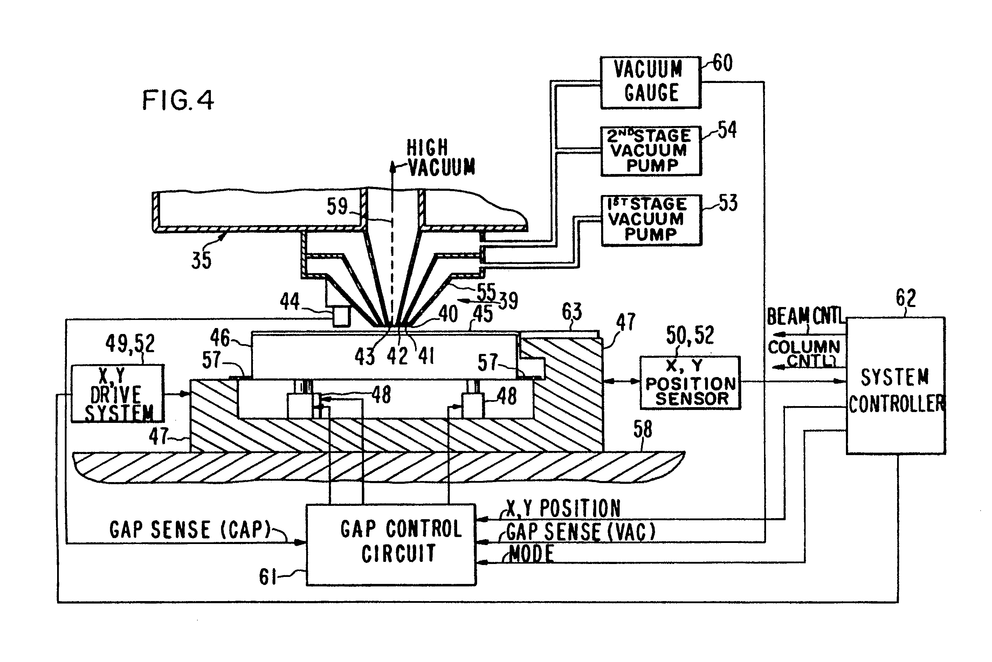

A serial loading capability is desirable in automated wafer processing equipment. Such a capability allows wafers to be moved from processing station to processing station and introduced to the next successive process without queing to form a batch. See F. T. Turner, et.al., "Individual Wafer Metallizing System - A Case History"; Industrial Research and Development, March 1981, p. 150 and April 1981, p. 148. With such an approach large batches of wafer are never placed at risk in a given process at any time. Such a serial loading capability is inherent with the vacuum envelope apparatus of the present invention since only a single wafer at a time is transported to the vacuum envelope apparatus and subjected to processing. This can be seen by reference to FIGS. 3 and 4 in which the lithography system is shown as having an alignment pad 63 positioned adjacent to wafer 45 on vacuum chuck 46. When a wafer 45 is being unloaded from or loaded onto vacuum chuck 46 on stage 47, stage 46 may be moved so that alignment pad 63 is placed in opposition to vacuum envelope 39, thereby allowing unloading and loading of wafers to occur unobstructed. When the tip of the vacuum envelope is positioned over the newly loaded wafer it is not necessary to reestablish processing vacuum as it has been retained.

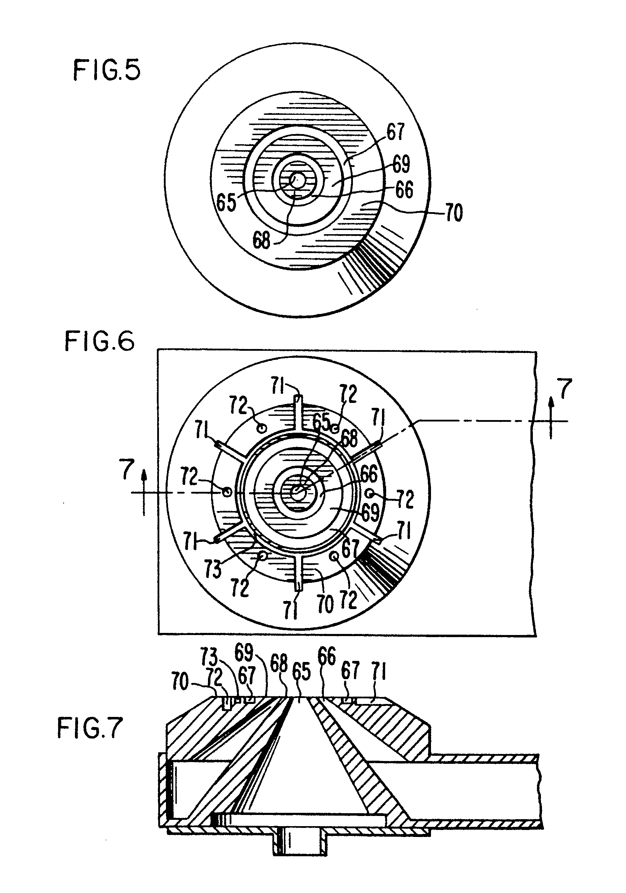

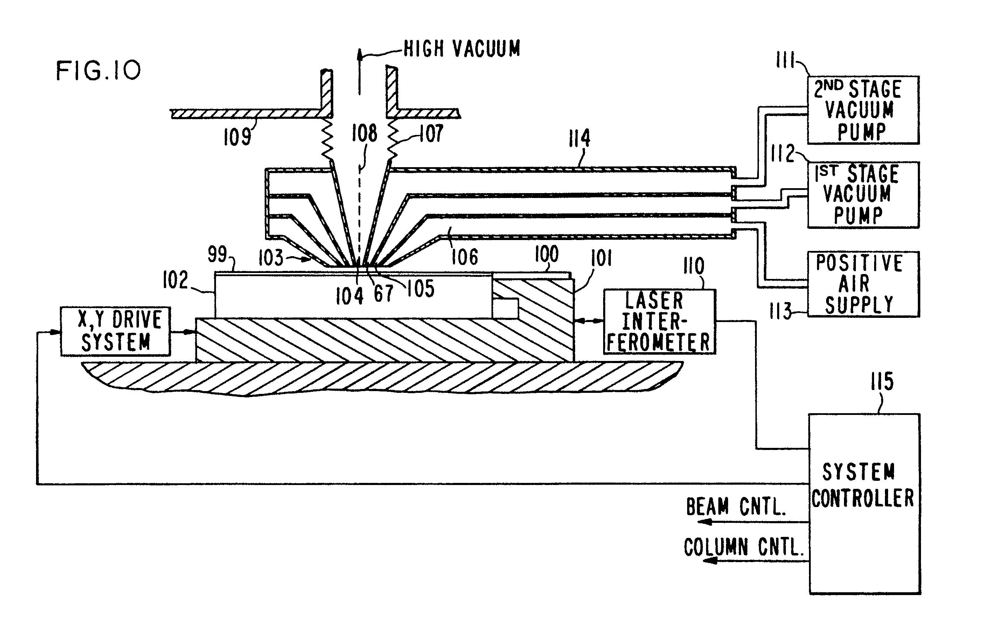

The tip of the vacuum envelope is shown in bottom view in FIGS. 5 and 6 and in cross section in FIG. 7. The tip in FIG. 5 corresponds to the three-stage vacuum envelope shown in side view schematic view in FIGS. 3 and 4; the tip in FIGS. 6 and 7 corresponds to the three-stage envelope plus air bearing embodiment shown in FIG. 10. For the three-stage vacuum envelope, high vacuum zone 65 is surrounded by conical member 68 and is connected to high vacuum pump 36; intermediate vacuum zone 66 is surrounded by annular conical member 69; and is connected to second stage vacuum pump 54; and intermediate vacuum zone 67 is surrounded by external conical member 70 and is connected to first stage vacuum pump 53. For the three-stage envelope plus air bearing, the same structure exists with the addition of air supply holes 72, annular groove 73 and radial air grooves 71. Air supply holes 72 are connected via zone 106 to a positive air supply 113. In operation, air is supplied at an appropriate pressure to produce an air bearing between surface 70 of the tip of the vacuum envelope and the surface of semiconductor wafer 99. In order to minimize the flow of air into vacuum groove 67, annular groove 73 is disposed to receive inwardly flowing air and conduct it through radial air grooves 71 outwardly to ambient. Relatively little air enters vacuum zone 67. Some air reaches ambient across the circumference of region 70, but most air flows through annular groove 73 and radial air grooves 71 to ambient.

For the air bearing embodiment of FIGS. 6, 7 and 10, it is not necessary to provide active z-axis tracking between stage 101, vacuum chuck 102 and vacuum envelope apparatus 103. Instead, envelope apparatus 103 is attached by bellows 107 to processing chamber 109, e.g., to the electron optical column which produces working beam 108. As stage 101 is moved by X,Y drive system 116 with respect to the tip 105 of envelope apparatus 103, relative z-axis movement is provided by a dynamic equilibrium between the spring forces of bellows 107 and the forces exerted by the air bearing.

For purposes of illustration throughout this specification the vacuum envelope apparatus has been shown with vertical orientation with the processing apparatus being positioned above the article being treated. In practice, any orientation may be selected. For the processing of semiconductor wafers, for example, a horizontal orientation of the vacuum envelope may be preferred so that the wafer is oriented vertically thereby avoiding the settling of particulates onto the surface of the wafer. And for vacuum processing on the surface of irregularly shaped articles the orientation of the vacuum envelope will necessarily change as the mobile apparatus traverses the surface of the article. Or, the orientation of the apparatus may be chosen to match the configuration and nature of the processing system and the article may be presented in an orientation appropriate for the formation of a graded seal with the the apparatus.

Also, for purposes of illustration the vacuum envelope apparatus has been shown to be conically shaped. This permits a focused beam process to be supported over a small local region. Generally, however, the shape of the tip is selected to accommodate the particular process. For example, a rectangular shape would support a line scan. And for electron beam welding the shape of the vacuum envelope may be tailored to accommodate the topography of the surface of the article being welded. In each case the vacuum seal is maintained between the tip of the envelope apparatus and the surface of the article and spans the distance from the internal processing zone to ambient. The size of the envelope should not be so large that the article being processed will experience appreciable bending due to the differential pressures between the various vacuum levels present on one surface of the article and the ambient present on the other surface. Generally, the more rigid the article or the lower the vacuum levels, the larger the area of the internal processing zone that may be exposed to vacuum. The number of vacuum stages surrounding the internal high vacuum region and separating it from ambient may be one where low vacuum requirements are present, or may be two or more where higher vacuum levels are required. The vacuum envelope, as shown in FIGS. 6, 7 and 10, may also ride on a planar air bearing in order to maintain the gap within an acceptable range. The applications for which the envelope apparatus of the present invention may be utilized are of two principal types: large surface area treatment and lithographic. For the latter application the internal high vacuum zone is small since the working beam is scanned only over distances of the order of a few millimeters with substrate translation accomplishing relative movement of larger size. Due to the depth of focus specifications, e.g., of an electron beam, it is often necessary to obtain accurate z-axis control as described in detail in EP-A-0106511 and EP-A-0109147. In order to utilize as much of the mask or silicon real estate as possible the envelope apparatus must function as close to the edges as possible, thereby creating a preference for small sized apparatus. For focused beam processing a conical shape is preferred since the shape provides good vacuum conductance to the tip and since the small tip is associated with small differential forces being applied to the article being processed. For gross applications, larger envelope structures of varied shapes may be employed since there typically will be less concern about the edges. As shown in FIGS. 8 and 9 moving conveyor 83 has a surface 82 having wells 84. The wells 84 are configured to receive semiconductor wafers 80 having flats 81. Preferably, the exposed surfaces of the semiconductor wafers are coplanar with the surface 82 of conveyor 83. Also, preferably, wafers are held in wells 84 by conventional vacuum chuck means (not shown). The conveyor may be moved underneath vacuum envelope 77 (shown in partial cross sectional view) positioned at the end, for example, of an ion implanter, plasma etching or sputter deposition machine. Processing is supported in internal vacuum zone 79 while an intermediate vacuum is established in zone 78. A graded vacuum seal is established from internal vacuum zone 79, underneath wall 76, across intermediate vacuum zone 78, underneath wall 77 and out to ambient. The overlap of internal vacuum zone 79 may cause processing to occur on the surface 82 adjacent wells 84; the impact of this processing may be minimized by using specific scan patterns in the case of ion implantation or by refinishing or replacing conveyor 83 periodically. Such a continuous approach to processing would be suitable for ribbon semiconductor materials fabricated for solar cell applications. For example, ion implantation of a silicon ribbon grown by edge defined film fed growth could be accomplished by running the ribbon under an envelope apparatus attached to an ion implanter.

It is an optional feature of the invention that grooves may be included on the external surface of the vacuum zone, the grooves extending from adjacent the exposure of the air flow zone onto the external surface through the periphery of its tip so that the air flows principally from the air flow zone to ambient. These grooves may comprise an annular ring-shaped groove located outside the outermost of all the intermediate vacuum processing zones and a series of radial grooves extending from the ring-shaped groove to the periphery of the tip.

Bellows may be provided for attachment to the vacuum processing apparatus whereby the envelope apparatus is held in Z axis position in dynamic equilibrium between the forces of the air bearing and the forces of the bellows. The air flow zone may be exposed on the external surface through a series of supply holes.

## Claims

1. Output device for use with a vacuum processing system for treating the surface of a thin, flexible workpiece and for use with a first vacuum source and a second vacuum source providing a lower vacuum than said first source, said device comprising:

    first vacuum envelope means (35) adapted for connection to said first vacuum source (36);

    second vacuum envelope means adapted for connection to said second vacuum source (54);

    said first and second envelope means defining first and second passages having respective first (43) and second apertures (42);

    said second aperture (42) surrounding said first aperture (43) in evenly spaced relationship thereto;

    said first and second apertures (42,43) lying in a plane;

    said first aperture (43) and at least a portion of said first envelope means transmitting the output of said vacuum process system to said surface; and

    means (49,52) for causing relative lateral motion between said surface and said apertures (41,42,43),

    characterised by means (61) for maintaining said apertures within a predetermined range of close spacing to said surface without any contact between the device and the surface, and at least one of the passages having a cross-sectional area that increases as the distance of said one passage increases from said plane.

2. A device as claimed in Claim 1 wherein the first vacuum source is adapted to provide a stronger vacuum than said second vacuum source.

3. A device as claimed in claim 1 or Claim 2 which further includes a third envelope means (55) positioned about said second envelope means and adapted for connection to a third vacuum source (53), said second source (54) providing a stronger vacuum than said third source (53), said third envelope (55) defining a third aperture (41) surrounding said second aperture (42) in evenly spaced relationship thereto, and aligned in said plane.

4. A device as claimed in any one of Claims 1 to 3 wherein said one passage is said first passage.

5. A device as claimed in Claim 4 wherein the cross sectional areas of both the first and second passages increase as the distance of said passages increases from said plane.

6. A device as claimed in claim 5 wherein the passages are configured to have at least one wall tapering inwardly toward the aperture and away from the remainder of the envelope toward the plane, the second passage having first and second walls respectively close to and remote from the beam axis (59,108), the second wall having a taper greater than any taper of the first wall.

7. A device as claimed in Claim 5 or Claim 6 wherein first and second fluid passages are formed in a truncated conical structure having a face defined by the plane, the conical structure extending inwardly toward the aperture and away from the remainder of the envelope toward the plane, the first and second passages being configured to have walls concentric with the beam axis, the walls being tapered inwardly toward the aperture and away from the remainder of the envelope toward the plane, the second passage having first and second walls respectively close to and remote from the beam axis, the second wall having a greater taper than the first wall so that the cross sectional areas of the first and second passages increase as the distance of the passages from said plane increases.

8. A device as claimed in any one of Claims 4 to 7 wherein the cross sectional area of the first passage increases as the distance of said passage increases from said plane.

9. A device as claimed in Claim 8 wherein the first passage is configured to have a wall concentric with the beam axis (59,108), said wall tapering inwardly toward the aperture (43) and away from the remainder of the envelope toward the plane.

10. A device as claimed in any one of Claims 1 to 9 in which said means (61) for maintaining said apertures within a predetermined spacing range from said surface includes an air bearing (106) surrounding said envelope means and communicating with a source (113) of positive air pressure.

11. A device as claimed in Claim 10 wherein said air bearing is arranged to direct air under said pressure substantially radially outwardly of said apertures.

12. A device as claimed in Claim 11 in which said air bearing (106) defines an annular surface aligned with said plane and grooved radially and annularly, said positive air pressure directing air substantially outwardly and along said radial grooves (71).

13. A device as claimed in any one of Claims 10 to 12 which further includes resilient bellow-like means (107) connecting said processing system and said device, said resilient means (107) and said air bearing (106) being in dynamic balance with each other during operation.

14. A device as claimed in any one of Claims 1 to 13 in which said means (49,52) for providing relative movement is arranged to move said workpiece laterally beneath said apertures.

15. Vacuum processing apparatus comprising an output device as claimed in any of the preceding Claims and a charged particle beam source located in the vacuum envelope (35) for deriving a charged particle beam that is directed through the first aperture (43) as a treating beam for the workpiece surface (45).

16. A method of treating the surface of a thin, flexible workpiece with a charged particle beam, comprising the steps of:

directing a beam from a source located in a vacuum envelope through an aperture (43) in a vacuum tip of the envelope onto a first portion of the workpiece surface that is approximately in registration with the aperture;

maintaining a gap between the vacuum tip and the first portion of the workpiece surface sufficient to prevent contact therebetween;

maintaining the first portion of the workpiece surface in vacuum while maintaining the remainder of the workpiece surface in an ambient environment outside of the vacuum, the vacuum being formed by using vacuum pump means (36, 54) to form a graded vacuum seal in the gap while the first portion of the workpiece surface is being treated by the charged particle beam, the gap and seal being such that the beam is exclusively in vacuum while propagating from the envelope to the first portion of the surface;

limiting the aperture (43) and the first portion of the workpiece surface to a sufficiently small area relative to the workpiece area to minimize bowing of the workpiece caused by differential pressure thereacross and to permit treatment close to the workpiece edge without loss of vacuum in the gap while providing high vacuum in the gap connecting the graded seal in the gap to the vacuum pump means through high vacuum conductance passages at least one of which increases in cross sectional area as the distance from the gap increases; and

moving the workpiece surface relative to the aperture so that different portions of the surface are successively in registration with the aperture without breaking the vacuum seal between the workpiece surface and the vacuum envelope interior so as to treat selected portions of the workpiece surface characterised by maintaining a gap between the vacuum tip and the first portion of the workpiece surface sufficient to prevent contact therebetween and connecting the graded seal in the gap to the vacuum pump means through high vacuum conductance passages at least one of which increases in cross sectional area as the distance from the gap increases.

## Revendications

1. Dispositif de sortie d'un système de traitement de surface sous vide de pièces minces et flexibles, utilisé avec une première source de vide et une deuxième source de vide fournissant un vide inférieur à celui de ladite première source, ledit dispositif comprenant:

des premiers moyens d'enveloppe de vide (35) prévus pour être reliés à ladite première source de vide (36),

des seconds moyens d'enveloppe de vide prévus pour être reliés à ladite deuxièmes source de vide,

lesdits premier et second moyens d'enveloppe définissant un premier et un second passage ayant respectivement une première (43) et une deuxième ouverture (42),

ladite deuxième ouverture (42) entourant ladite première ouverture (43) d'un espacement uniforme,

lesdites première et deuxième ouvertures (42,43) étant disposées selon un plan,

ladite première ouverture (43) et au moins une portion desdits premiers moyens d'enveloppe transmettant la sortie dudit système de traitement sous vide à ladite surface, et

des moyens (49,52) d'action d'un mouvement latéral relatif entre ladite surface et lesdites ouvertures (41,42,43),

caractérisé en ce qu'il comprend en outre

des moyens (61) pour maintenir lesdites ouvertures à l'intérieur d'un espacement resserré prédéterminé par rapport à ladite surface sans contact entre le dispositif et la surface, et en ce qu'au moins un des passages a une surface de section transversale qui augmente lorsque la distance de ce dit passage par rapport audit plan augmente.

2. Dispositif selon la revendication 2, caractérisé en ce que la première source de vide est prévue pour fournir un vide plus poussé que celui de ladite deuxième source de vide.

3. Dispositif selon l'une des revendications 1 ou 2, caractérisé en ce qu'il comprend aussi des troisièmes moyens d'enveloppe (55) disposés autour desdits deuxièmes moyens d'enveloppe et reliés à une troisième source de vide (53), ladite deuxième source (54) fournissant un vide plus poussé que ladite troisième source (53), ladite troisième enveloppe (55) définissant une troisième ouverture (41) entourant ladite deuxième ouverture (42) d'un espacement uniforme et alignée dans ledit plan.

4. Dispositif selon l'une des revendications 1 à 3, caractérisé en ce que ledit passage correspond audit premier passage.

5. Dispositif selon la revendication 4, caractérisé en ce que les surfaces des sections transversales des premier et second passages augmentent lorsque la distance desdits passages par rapport audit plan augmente.

6. Dispositif selon la revendication 5, caractérisé en ce que les passages sont configurés pour avoir au moins une paroi inclinée vers l'intérieur en direction de l'ouverture et éloignée du reste de l'enveloppe à proximité du plan, le deuxième passage ayant une première et une deuxième paroi respectivement proche et séparée de l'axe du faisceau (59,108), la deuxième paroi ayant une inclinaison plus importante que chaque inclinaison de la première paroi.

7. Dispositif selon l'une des revendications 5 ou 6, caractérisé en ce qu'un premier et un deuxième passage de fluide sont formés dans une structure en tronc de cône ayant une face définie par le plan, la structure conique s'étendant vers l'intérieur en direction de l'ouverture et éloignée du reste à proximité du plan, les premier et deuxième passages étant configurés pour avoir des parois concentriques à l'axe du faisceau, les parois étant inclinées vers l'intérieur en direction de l'ouverture et éloignées du reste de l'enveloppe à proximité du plan, le deuxième passage ayant une première et une deuxième paroi respectivement proche et séparée de l'axe du faisceau, la deuxième paroi ayant une inclinaison plus importante que la première paroi, afin que les surfaces des sections transversales des premier et deuxième passages augmentent lorsque la distance des passages par rapport au plan augmente.

8. Dispositif selon l'une des revendications 4 à 7, caractérisé en ce que la surface de la section transversale du premier passage augmente lorsque la distance dudit passage par rapport au plan augmente.

9. Dispositif selon la revendication 8, caractérisé en ce que le premier passage est configuré pour avoir une paroi concentrique à l'axe du faisceau (59,108), ladite paroi étant inclinée vers l'intérieur en direction de l'ouverture (43) et éloignée du reste de l'enveloppe à proximité du plan.

10. Dispositif selon l'une des revendications 1 à 9, caractérisé en ce que lesdits moyens (61) pour maintenir lesdites ouvertures à l'intérieur d'un espacement resserré prédéterminé par rapport à ladite surface comprennent un support pneumatique (106) entourant lesdits moyens d'enveloppe et relié à une source (113) d'air comprimé.

11. Dispositif selon la revendication 10, caractérisé en ce que ledit support pneumatique est disposé pour diriger de l'air sous pression substantiellement radialement vers l'extérieur desdites ouvertures.

12. Dispositif selon la revendication 11, caractérisé en ce que ledit support pneumatique (106) définit une surface annulaire alignée avec ledit plan et rainurée radialement et annulairement, ledit air comprimé étant dirigé substantiellement vers l'extérieur et le long desdites rainures radiales (71).

13. Dispositif selon l'une des revendications 10 à 12, caractérisé en ce qu'il comprend aussi des moyens de soufflet élastiques (107) reliant ledit système de traitement et ledit dispositif, lesdits moyens élastiques (107) et ledit support pneumatique (106) étant équilibrés dynamiquement l'un avec l'autre en fonctionnement.

14. Dispositif selon l'une des revendications 1 à 13, caractérisé en ce que lesdits moyens (49,52) d'action d'un mouvement relatif sont disposés pour déplacer ladite pièce latéralement au-dessous desdites ouvertures.

15. Appareil de traitement sous vide comprenant un dispositif de sortie selon l'une des revendications précédentes et une source de faisceau de particules chargées disposée dans l'enveloppe sous vide (35) pour dériver un faisceau de particules chargées qui est dirigé par la première ouverture (43) comme faisceau de traitement de la surface de la pièce (45).

16. Procédé de traitement de surface d'une pièce mince flexible par un faisceau de particules chargées comprenant les étapes de:

diriger un faisceau à partir d'une source disposée dans une enveloppe sous vide par une ouverture (43) dans une extrémité sous vide de l'enveloppe vers une première portion de la surface de la pièce qui est approximativement en concordance avec l'ouverture,

maintenir un espace suffisant entre l'extrémité sous vide et la première portion de surface de la pièce pour prévenir un contact entre elles,

maintenir la première portion de surface de la pièce sous vide tout en maintenant le reste de la surface de la pièce dans un environnement ambiant hors vide, le vide étant formé en employant des moyens de pompe à vide (36,54) pour former une étanchéité graduée au vide dans l'espace alors que la première portion de surface de la pièce est en traitement par le faisceau de particules chargées, l'espace et l'étanchéité étant tels que le faisceau est exclusivement dans le vide qui se propage depuis l'enveloppe vers la première portion de surface,

limiter l'ouverture (43) et la première portion de la surface de la pièce sur une surface relativement petite par rapport à la surface de la pièce, pour minimiser la courbure de la pièce par la différence des pressions à travers elle et pour permettre un traitement à proximité de l'arête de la pièce sans perte de vide dans l'espace tout en fournissant un vide élevé dans l'espace reliant l'étanchéité graduée dans l'espace aux moyens de pompe à vide par les passages conducteurs sous vide élevé, au moins l'un d'entre eux augmentant de surface de section transversale lorsque la distance par rapport à l'espace augmente,

déplacer la surface de la pièce relativement à l'ouverture afin que différentes portions de la surface soient successivement en concordance avec l'ouverture sans briser l'étanchéité au vide entre la surface de la pièce et l'intérieur de l'enveloppe sous vide afin de traiter des portions sélectionnées de la surface de la pièce, caractérisé en ce qu'un espace suffisant est maintenu entre l'extrémité sous vide et la première portion de la surface de la pièce afin de prévenir un contact entre elles et relier l'étanchéité graduée dans l'espace aux moyens de pompe à vide par les passages conducteurs sous vide élevé, au moins l'un d'entre eux augmentant de surface de section transversale lorsque la distance par rapport au vide augmente.

**Patentansprüche**

1. Austrittsvorrichtung zur Verwendung mit einem Vakuumbearbeitungssystem zur Behandlung der Oberfläche eines dünnen, flexiblen Werkstückes und zur Verwendung mit einer ersten Vakuumquelle und einer zweiten Vakuumquelle, welche ein niedrigeres Vakuum erzeugt als die genannte erste Quelle, wobei die Vorrichtung umfasst:

erste Vakuumummantelungsmittel (35), welche zur Verbindung mit der genannten ersten Vakuumquelle (36) angepasst sind;

zweite Vakuumummantelungsmittel, welche zur Verbindung mit der genannten zweiten Vakuumquelle (54) angepasst sind;

wobei die ersten und zweiten Ummantelungsmittel erste und zweite Durchgänge definieren, welche entsprechende erste (43) und zweite Oeffnungen (42) definieren;

die zweite Oeffnung (42) die genannte erste Oeffnung (43) in gleichmässigem Abstand zu derselben umgibt;

die genannten ersten und zweiten Oeffnungen (42, 43) in einer Ebene liegen;

die genannte erste Oeffnung (43) und mindestens ein Teil des genannten ersten Ummantelungsmittels den Ausstoss des genannten Vakuumbearbeitungssystems zur genannten Oberfläche übertragen; und

Mittel (49, 52) zum Bewirken einer relativen seitlichen Bewegung zwischen der genannten Oberfläche und den genannten Oeffnungen (41, 42, 43),

gekennzeichnet durch Mittel (61) zum Halten der genannten Oeffnungen innerhalb eines vorbestimmten Bereiches eines nahen Abstandes zur genannten Oberfläche ohne jeden Kontakt zwischen der Vorrichtung und der Oeberfläche, wobei mindestens einer der Durchgänge eine Querschnittsfläche aufweist, die zunimmt, wenn die Distanz des genannten einen Durchganges von der genannten Ebene zunimmt.

2. Vorrichtung nach Patentanspruch 1, dadurch gekennzeichnet, dass die erste Vakuumquelle ausgebildet ist, um ein stärkeres Vakuum als die genannte zweite Vakuumquelle zu erzeugen.

3. Vorrichtungh nach Patentanspruch 1 oder 2, gekennzeichnet durch ein drittes Ummantelungsmittel (55), welches über dem genannten zweiten Ummantelungsmittel positioniert ist und zur Verbindung mit einer dritten Vakuumquelle (53) ausgebildet ist, wobei die genannte zweite Quelle (54) ein stärkeres Vakuum liefert als die genannte dritte Quelle (53), die genannte dritte Ummantelung (55) eine dritte Oeffnung (41) definiert, welche die genannte zweite Oeffnung (42) in gleichmässigem Abstand zu derselben umgibt und in der genannten Ebene ausgerichtet ist.

4. Vorrichtung nach einem der Patentansprüche 1 bis 3, dadurch gekennzeichnet, dass der genannte eine Durchgang der genannte erste Druchgang ist.

5. Vorrichtung nach Patentanspruch 4, dadurch gekennzeichnet, dass die Querschnittsfläche des ersten und zweiten Durchganges zunimmt, wenn die Distanz der genannten Durchgänge von der Ebene zunimmt.

6. Vorrichtung nach Patentanspruch 5, dadurch gekennzeichnet, dass die Durchgänge so ausgebildet sind, das mindestens eine Wand nach innen gegen die Oeffnung und weg vom Rest der Ummantelung gegen die Ebene geneigt ist, der zweite Durchgang eine erste und eine zweite Wand aufweist, die nah resp. entfernt von der Strahlachse (59, 108) sind, wobei die zweite Wand eine Neigung aufweist, die grösser ist als jegliche Neigung der ersten Wand.

7. Vorrichtung nach Patentanspruch 5 oder 6, dadurch gekennzeichnet, dass die ersten und zweiten Fluiddurchgänge als abgestumpfte konische Struktur mit einer durch die Ebene definierten Stirnfläche ausgebildet sind, wobei sich die konische Struktur nach innen gegen die Oeffnung und weg vom Rest der Ummantelung gegen die Ebene erstreckt, die ersten und zweiten Durchgänge so ausgebildet sind, dass sie konzentrisch mit der Strahlachse ausgebildete Wände aufweisen, wobei die Wände nach innen gegen die Oeffnung und weg vom Rest der Ummantelung gegen die Ebene geneigt sind, der zweite Durchgang eine erste und eine zweite Wand aufweist, die nahe resp. entfernt von der Strahlachse angeordnet sind, die zweite Wand eine grössere Neigung als die erste Wand aufweist, so dass die Querschnittsflächen der ersten und zweiten Durchgänge zunehmen, wenn die Distanz der Durchgänge von der genannten Ebene zunimmt.

8. Vorrichtung nach einem der Patentansprüche 4 bis 7, dadurch gekennzeichnet, dass die Querschnittsfläche des ersten Durchganges zunimmt, wenn die Distanz des genannten Durchganges von der Ebene zunimmt.

9. Vorrichtung nach Patentanspruch 8, dadurch gekennzeichnet, dass der erste Durchgang derart ausgebildet ist, dass er eine Wand aufweist, die konzentrisch mit der Strahlachse (59, 108) ist, wobei die Wand nach innen gegen die Oeffnung (43) und weg vom Rest der Ummantelung gegen die Ebene geneigt ist.

10. Vorrichtung nach einem der Patentansprüche 1 bis 9, dadurch gekennzeichnet, dass die genannten Mittel (61) zum Halten der genannten Oeffnungen innerhalb eines vorbestimmten Abstandbereiches von der genannten Oberfläche ein Luftlager (106) umfassen, welches die genannten Ummantelungsmittel umgibt und mit einer Quelle (113) von positivem Luftdruck kommuniziert.

11. Vorrichtung nach Patentanspruch 10, dadurch gekennzeichnet, dass das genannte Luftlager so angeordnet ist, um Luft unter dem genannten Druck im wesentlichen radial nach aussen der genannten Oeffnungen zu richten.

12. Vorrichtung nach Patentanspruch 11, dadurch gekennzeichnet, dass das genannte Luftlager (106) eine ringförmige Fläche bildet, die mit der genannten Ebene ausgerichtet ist und radial und ringförmig gerillt ist, wobei der genannte positive Luftdruck Luft im wesentlichen nach aussen und entlang den genannten radialen Rillen (71) leitet.

13. Vorrichtung nach einem der Patenetansprüche 10 bis 12, gekennzeichnet durch federnde faltenbalgähnliche Mittel (107), welche das genannte Bearbeitungssystem und die genannte Vorrichtung verbinden, wobei die genannten federnden Mittel (107) und das genannte Luftlager (106) während dem Betrieb in dynamischem Gleichgewicht miteinander sind.

14. Vorrichtung nach einem der Patentansprüche 1 bis 13, dadurch gekennzeichnet, dass das genannte Mittel (49, 52) zur Erzeugung einer relativen Bewegung derart angeordnet ist, um das genannte Werkstück seitlich unter den genannten Oeffnungen zu bewegen.

15. Vakuumbearbeitungsapparat mit einer Vorrichtung nach einem der vorgehenden Patentansprüche, gekennzeichnet durch eine Quelle für einen Strahl geladener Partikel, welche in der Vakuumummantelung (35) angeordnet ist, zum Ableiten eines Strahls geladener Partikel, welcher durch die erste Oeffnung (43) geleitet ist als ein Behandlungsstrahl für die Werkstückoberfläche (45).

16. Verfahren zur Behandlung der Oberfläche eines dünnen, flexiblen Werkstückes mit einem Strahl geladener Partikel, gekennzeichnet durch folgende Schritte:

Leiten eines Strahls von einer in einer Vakuumummantelung angeordneten Quelle, durch eine Oeffnung (43) in einer Spitze unter Vakuum der Ummantelung auf einen ersten Teil der Werkstückoberfläche, welcher angenähert in Lagegenauigkeit mit der Oeffnung ist;

Aufrechterhalten eines genügenden Zwischenraumes zwischen der Spitze unter Vakuum und dem ersten Teil der Werkstückoberfläche, um Kontakt zwischen diesen zu verhindern;

Halten des ersten Teils der Werkstückoberfläche im Vakuum, während der Rest der Werkstückoberfläche in Umgebung ausserhalb des Vakuum gehalten wird, das Vakuum durch Verwendung von Vakuumpumpenmitteln (36, 54) gebildet wird, um eine abgestufte Vakuumdichtung im Zwischenraum zu bilden, während der erste Teil der Werkstückoberfläche durch den Strahl geladener Partikel behandelt wird, der Zwischenraum und die Dichtung so ausgebildet sind, dass der Strahl sich ausschliesslich im Vakuum befindet, während er sich von der Ummantelung zum ersten Teil der Oberfläche ausbreitet;

Begrenzung der Oeffnung (43) und des ersten Teils der Werkstückoberfläche auf eine genügend kleine Fläche relativ zur Werkstückfläche, um die durch die Druckdifferenz quer über das Werkstück erzeugte Krümmung des Werkstückes zu minimalisieren und eine Behandlung nahe am Werkstückrand ohne Verlust von Vakuum im Zwischenraum zu ermöglichen, währenddem hohes Vakuum im Zwischenraum geschaffen wird, und die abgestufte Dichtung im Zwischenraum mit den Vakuumpumpenmitteln durch Hochvakuumleitungen verbunden wird, wobei sich die Querschnittsfläche mindestens einer der Leitungen erhöht, wenn sich die Distanz vom Zwischenraum erhöht; und

Bewegen der Werkstückoberfläche relativ zur Oeffnung, so dass verschiedene Teile der Oberfläche nacheinander in Lagegenauigkeit mit der Oeffnung sind, ohne dass die Vakuumdichtung zwischen der Werkstückoberfläche und dem Inneren der Vakuumummantelung unterbrochen wird, um so ausgewählte Teile der Werkstückoberfläche zu behandeln,

dadurch gekennzeichnet, dass ein genügender Zwischenraum zwischen der Spitze unter Vakuum und dem ersten Teil der Werkstückoberfläche aufrechterhalten wird, um einen Kontakt zwischen diesen zu verhindern und die abgestufte Dichtung im Zwischenraum mit den Vakuumpumpenmitteln durch Hochvakuumleitungen verbunden wird, wobei sich die Querschnittsfläche mindestens einer der Leitungen erhöht, wenn sich die Distanz vom Zwischenraum erhöht.

FIG.1

FIG.2

FIG.3

ELECTRON SOURCE

35

ILLUMINATION AND SHAPING

DEMAGNIFICATION

PROJECTION AND DEFLECTION

38

36
HIGH VACUUM PUMP

37
WAFER HANDLING SYSTEM

X AXIS DRIVE

49

60

39 55
45 44
46
43 40
48
42 41
63
47
52 Y POS SENSOR
54
2ND STAGE VACUUM PUMP
53
1ST STAGE VACUUM PUMP
58
50 X POS SENSOR
55

Z
Y
X

Y AXIS DRIVE
51

FIG.4

HIGH
VACUUM

VACUUM
GAUGE — 60

2ND STAGE
VACUUM
PUMP — 54

1ST STAGE
VACUUM
PUMP — 53

59

35

44

55 39
40 45
43 42 41

63
47

49,52
X,Y
DRIVE
SYSTEM

46
57

57

50,52
X,Y
POSITION
SENSOR

BEAM CNTL

COLUMN
CNTL

62

SYSTEM
CONTROLLER

47

48

48

58

GAP SENSE (CAP)

GAP CONTROL
CIRCUIT

61

X,Y POSITION
GAP SENSE (VAC)
MODE

EP 0 106 510 B1

17

FIG.5

FIG.6

FIG.7

# FIG.8

# FIG.9

FIG.10

HIGH VACUUM

109  108  107  114

2ND STAGE VACUUM PUMP  111

1ST STAGE VACUUM PUMP  112

POSITIVE AIR SUPPLY  113

99  103  106  100  101  110

102  104  67  105

X,Y DRIVE SYSTEM

LASER INTER-FEROMETER

SYSTEM CONTROLLER  115

BEAM CNTL.

COLUMN CNTL.

EP 0 106 510 B1